# EUROPÄISCHE PATENTSCHRIFT

(11) **EP 0 564 923 B1**
(45) Veröffentlichungstag und Bekanntmachung des Hinweises auf die Patenterteilung: **10.09.1997**
(21) Anmeldenummer: 93105025.6
(22) Anmeldetag: 26.03.1993
(51) Int. Cl.: H03K 3/03, G01R 25/00

(54) **Verfahren und Vorrichtung zur Phasenmessung**
Method and device for phase measuring
Procédé et dispositif de mesure de phase

(30) Priorität: 08.04.1992 DE 4211701
(43) Veröffentlichungstag der Anmeldung: 13.10.1993
(73) Patentinhaber: DEUTSCHE THOMSON-BRANDT GMBH, 78048 Villingen-Schwenningen (DE)
(72) Erfinder: Rothermel, Albrecht, W-7730 VS-Villingen (DE)

(56) Entgegenhaltungen:
- EP-A- 0 225 396
- EP-A- 0 439 178
- EP-A- 0 467 712
- DE-A- 4 123 388

## Beschreibung

Die vorliegende Erfindung betrifft ein Verfahren nach Anspruch 1 sowie eine zur Durchführung des erfindungsgemäßen Verfahrens geeignete Vorrichtung gemäß dem Anspruch 2.

Die vorliegende Erfindung bezieht sich auf getaktete digitale Systeme. Bei getakteten Schaltungen werden die Eingänge üblicherweise zu diskreten Zeitpunkten abgetastet. Wenn der Takt zum Beispiel 1 MHz beträgt, treten die Takte im Abstand von einer Mikrosekunde auf. Alle Eingangssignale werden dann normalerweise auch mit einer Mikrosekunde Abstand, das heißt genau zu den Zeitpunkten des Taktes, abgetastet und ausgewertet.

Das bedeutet, daß die zeitliche Auflösung der Eingangssignale nicht feiner als eine Mikrosekunde sein kann. Ob eine Änderung eines Eingangssignales, zum Beispiel 0,1 oder 0,5 Mikrosekunden vor einem Takt stattgefunden hat, läßt sich durch eine mit zum Beispiel ein MHz getaktete Digitalschaltung nicht unterscheiden.

Zu diesem Zweck sind Phasenmeßschaltungen geeignet, wie sie beispielsweise in DE-A-41 23 388 vorgestellt wurden. Diese können die Phasenbeziehung zwischen einem Eingangssignal, auch Testsignal genannt, und einem Referenzsignal, das gleich sein kann mit einem Systemtakt oder von diesem abgeleitet sein kann, bestimmen. Damit kann beispielsweise erreicht werden, daß nachgeschaltete Stufen durch das Eingangssignal gesteuert, das heißt getaktet, werden, und nicht durch den Systemtakt.

Wenn in dem Eingangssignal eine signifikante Änderung auftritt, wie zum Beispiel eine negative Flanke, wird die relative Zeitlage, die diese Änderung im Taktraster hat, gemessen, gespeichert und ausgegeben. Mit einer solchen Schaltung gibt es die Möglichkeit, die relative zeitliche Lage einer signifikanten Änderung des Eingangssignals in dem Taktraster der Digitalschaltung zu messen.

Das Ausgangssignal dieser Phasenmeßschaltung erscheint jedoch prinzipbedingt um eine gewisse Zeit verzögert gegenüber der Änderung am Eingangssignal. Der Zeitpunkt, zu dem das Ausgangssignal erscheint, ist also bestimmt durch den Zeitpunkt der Änderung im Eingangssignal und weiteren Verzögerungszeiten. Das Ausgangssignal kann sozusagen jeder Zeit erscheinen. Dadurch kann es zu Konflikten mit nachfolgenden Stufen kommen. Diese tasten Ihrer Eingangssignale zu Zeitpunkten ab, die durch den Takt festgelegt sind.

Es ist also der Fall denkbar, daß das Ausgangssignal der Phasenmeßschaltung genau zu dem Zeitpunkt erscheint, zu dem es abgetastet wird. Es gibt dann eine Entscheidungsunsicherheit, ob das Ausgangssignal noch vor dem Takt erschienen ist, oder erst danach. Die Entscheidung ist vom Zufall oder vom Rauschen bestimmt. Wenn die Entscheidung falsch getroffen wird, entspricht das einem Phasenmeßfehler von einem ganzen Takt, also zum Beispiel von einer Mikrosekunde bei einem MHz Taktfrequenz.

Aus der EP 0 439 178 A1 ist eine Phasendifferenzcodier-schaltung bekannt. Darin wird ein erster Impuls von einer Schaltung verarbeitet, die mehrere Verzögerungsstufen enthält. Die Ausgangssignale der Verzögerungsstufen werden jeweils einem Zwischenspeicher zugeführt. Die Zwischenspeicher stehen dann über logische EXCLUSIV-ODER-Gatter mit einer Encodierschaltung in Verbindung. Die Zwischenspeicher werden mit einer Flanke eines zweiten Impulses getaktet. Durch die Anordnung wird die Phasendifferenz zwischen den beiden Impulsen gemessen Die Encodierschaltung ermittelt auf Grund des Anliegens einer logischen "0" an einem ihrer Eingänge ein dementsprechendes Datenwort, das über die Phasendifferenz informiert.

Aus der EP 0 467 712 A3 ist ein Phasendemodulatorschaltkreis für PSK-modulierte Signale bekannt. Darin wird ein Ring-Oszillator verwendet, der eine Anzahl von Verzögerungsglieder enthält. Die Ausgänge der einzelnen Verzögerungsglieder sind auf einen Zwischenspeicher geführt. Die Ausgänge der Zwischenspeicher werden einer Encodierschaltung zugeführt. Die Zwischenspeicher und die Encodierschaltung werden mit einem von dem empfangenen Signal abgeleiteten Taktsignal getaktet. Am Ausgang der Encodierschaltung wird ein digitales Signal abgegeben, das über den Phasenzustand des PSK-modulierten Signals Auskunft gibt.

Aus der EP 0 225 396 A1 ist eine digitale Phasenmeßschaltung bekannt. Diese bestimmt die Phasendifferenz zwischen einem ersten Taktsignal und einem zweiten Taktsignal. Dazu wird das erste Taktsignal einer Schaltung zugeführt, die aus Verzögerungsgliedern besteht. Die Ausgänge der Verzögerungsglieder sind jeweils zwei verschiedenen Registern zugeleitet. Beide Register werden unterschiedlich getaktet. Das erste Register wird mit dem Taktsignal getaktet, das auch der Schaltung mit den Verzögerungsgliedern zugeführt ist, und daß zweite Register wird mit dem zu vergleichenden Taktsignal getaktet. Die Ausgänge der beiden Register sind über EXCLUSIV-ODER-Gatter miteinander verknüpft und einer Auswerteschaltung in Form eines Vielfachaddierers zugeführt.

Es ist die Aufgabe der vorliegenden Erfindung, die Entscheidungsunsicherheit bezüglich des Erscheinen des Ausgangssignals der Phasenmeßschaltung zu verhindern und die Ausgangssignale der Phasenmeßschaltung, die zu jedem Zeitpunkt erscheinen können, mit dem Arbeitstakt nachgeschalteter Stufen ohne Unsicherheit abzutasten. Diese Aufgabe wird gelöst durch ein Verfahren nach Anspruch 1 und durch eine Vorrichtung gemäß dem ersten Sachanspruch.

Erfindungsgemäß werden Vergleichssignale, die gebildet werden aufgrund eines Phasenvergleiches zwischen einem Testsignal und einem Referenzsignal, in zwei Gruppen aufgeteilt. Eine erste Gruppe wird dabei verglichen mit einer ersten Phasenlage eines Arbeitstaktes von nachgeschalteten Stufen und eine zweite Gruppe der Vergleichssignale wird verglichen mit einer zweiten Phasenlage des Arbeitstaktes der nachgeschalteten Stufen.

Das Referenzsignal kann beispielsweise aus einem Arbeitstakt für die Phasenmeßschaltung und/oder der nachgeschalteten Stufen abgeleitet oder mit diesem identisch sein.

Die Phasenlagen des Referenzsignales können dabei derart definiert sein, daß bei einem digitalen Verlauf (high, low; bzw. "1", "0") zwischen diesen beiden Zuständen unterschieden wird.

Es ist ebenfalls möglich, bei einem analogen Referenzsignal, beispielsweise, das beispielsweise sinusförmig, sägezahnförmig oder dergleichen verläuft, eine Unterscheidung nach vorgegebenen Amplitudenwerten vorzunehmen.

Durch die Unteransprüche werden weitere vorteilhafte Ausgestaltungen angegeben.

So ist es beispielsweise denkbar, daß jedes der Vergleichssignale über eine eigene Vergleichsleitung geführt wird und diese Vergleichsleitungen aufgeteilt sind in zwei Gruppen. Eine erste Gruppe von Vergleichsleitungen wird einem ersten Vergleichsbaustein, beispielsweise einem ersten Register, und die zweite Gruppe von Vergleichsleitungen wird einem zweiten Baustein, beispielsweise einem zweiten Register, zugeführt. Dabei wird das erste Register durch die erste Phasenlage des Referenzsignales und das zweite Register durch die zweite Phasenlage des Referenzsignales angesteuert.

Die entsprechenden Ausgangssignale können weiteren Stufen, wie beispielsweise einem weiteren Register, einer Auswerteschaltung oder dergleichen zugeführt werden.

Weitere Merkmale, Vorteile und Einzelheiten der Erfindung werden in den folgenden Ausführungsbeispielen anhand der Zeichnung erläutert. Dabei zeigen:
- Figur 1:: ein Blockschaltbild eines bevorzugten Ausführungsbeispieles;
- Figur 2:: ein Zeitdiagramm zur Erläuterung der Funktion des Ausführungsbeispieles nach Fig. 1.

Bevor auf die Beschreibung der Ausführungsbeispiele näher eingegangen wird, sei darauf hingewiesen, daß die in den Figuren einzeln dargestellten Blöcke lediglich zum besseren Verständnis der Erfindung dienen. Möglicherweise sind einzelne oder mehrere dieser Blöcke zu Einheiten zusammengefaßt. Diese können in integrierter oder als Hybridtechnik oder als programmgesteuerter Mikrorechner, beziehungsweise als Teil eines zu seiner Steuerung geeigneten Programmes realisiert sein.

Die in den einzelnen Stufen enthaltene Elemente können jedoch auch getrennt ausgeführt werden.

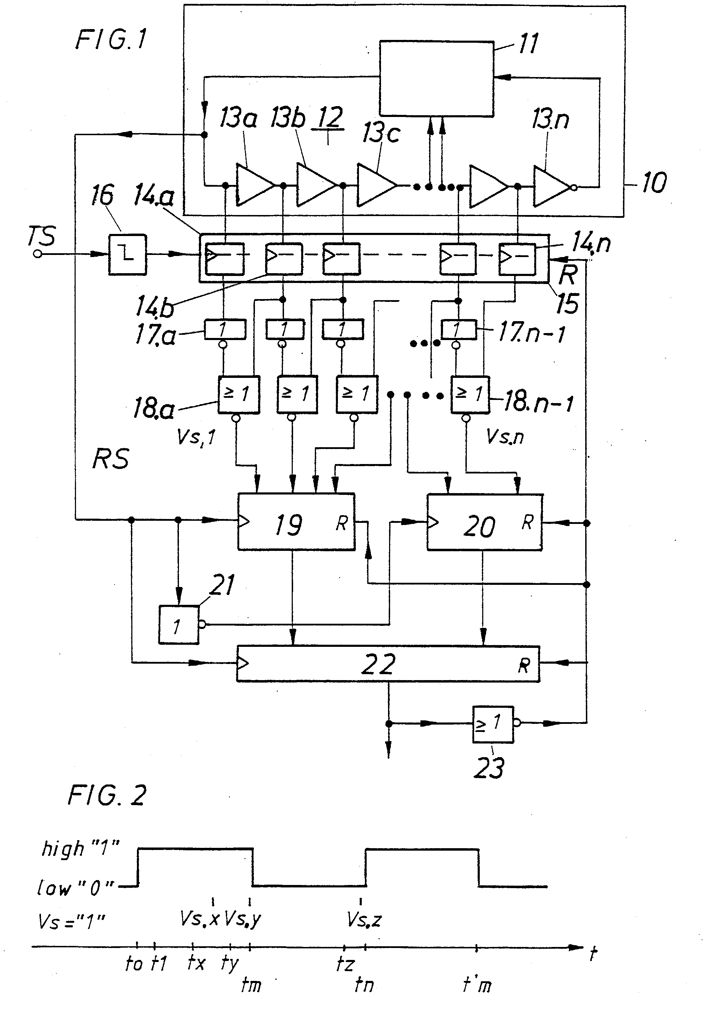

Das Blockschaltbild nach Figur 1 zeigt einen Oszillator 10, der eine Stufe 11 und einen Verzögerungskette 12 aufweist. Diese Verzögerungskette 12 wird gebildet aus Verzögerungselementen 13.a, 13.b, ..., 13.n. Ein Oszillator der hier dargestellten Art ist bereits in DE-A-41 23 388.3 ausführlich beschrieben und es soll an dieser Stelle nicht weiter darauf eingegangen werden.

Die Eingangssignale der Verzögerungselemente werden je einem Schalteingang eines Schaltkontaktes 14.a,...,14.n zugeführt, die zu einer Schaltstufe 15 gehören. Die Schaltkontakte 14 sind in diesem Ausführungsbeispiel als Register ausgestaltet und werden gesteuert durch eine Schwellwertstufe 16, deren Ausgangssignal gebildet wird aufgrund einer signifikanten Änderung eines ihr zugeführten Testsignales Ts.

Die Ausgänge der Register 14 führen teilweise zu Invertern 17 und teilweise direkt zu NOR-Gattern 18. Der Aufbau und die Funktionsweise der bisher genannten Schaltungsblöcke ist ebenfalls in der genannten älteren Anmeldung beschrieben und es soll an dieser Stelle nicht weiter darauf eingegangen werden.

Die Ausgangssignale der NOR-Gatter 18 bilden sogenannte Vergleichssignale Vs.1, ..., Vs.n. Diese werden jeweils über eine eigene Vergleichsleitung geführt. Eine erste Gruppe dieser Vergleichsleitungen führt zu einem ersten Register 19 und eine zweite Gruppe von Vergleichsleitungen führt zu einem zweiten Register 20. Das erste Register 19 wird in diesem Ausführungsbeispiel gesteuert durch das Referenzsignal Rs, das durch den Oszillator 10 erzeugt wird. Dieses wird ebenfalls einem Inverter 21 zugeführt, dessen Ausgangssignal zur Steuerung des zweiten Registers 20 dient.

Die Ausgangssignale der Register 19, 20 werden einem dritten Register 22 zugeführt, das ebenfalls durch das Referenzsignal Rs gesteuert wird.

Das Ausgangssignal des Registers 22 enthält zum einen die Informationen zur eindeutigen Phasen-Zuordnung des Testsignales Ts und kann weiteren hier nicht dargestellten Auswertestufen zugeführt werden. Zum anderen wird das Ausgangssignal des Registers 22 einem NOR-Gatter 23 zugeführt, dessen Ausgangssignal als Resetsignal für die Register 19, 20, 22 sowie der Schaltvorrichtung 15 dient.

Die Funktion des Ausführungsbeispiels gemäß Figur 1 wird im folgenden mit Hilfe von Figur 2 erläutert.

Das Referenzsignal, das hier als Rechtecksignal ausgebildet ist, möge
zu einem Zeitpunkt to eine Flanke von low nach high,
zu einem Zeitpunkt tm eine Flanke von high nach low und
zu einem Zeitpunkt tn wiederum eine Flanke von low nach high
aufweisen. Diese Schwingung möge periodisch verlaufen.

Zu einem Zeitpunkt tx weist das Testsignal Ts eine signifikante Änderung auf, wodurch die Schwellwertstufe 16 derart angesteuert wird, daß die Register 14 übernehmen. Durch interne Laufzeitverzögerungen wird bewirkt, daß ein Vergleichssignal Vs.x zu einem späteren Zeitpunkt als tx von logisch null nach logisch high geschaltet wird. Der Zeitpunkt tx ist in Fig. 2 dabei so gewählt, daß der spätere Zeitpunkt, zu dem Vs.x umgeschaltet wird, noch vor der Flanke des Referenzsignales bei TM liegt.

Bei einem weiteren Beispiel sei angenommen, daß zum Zeitpunkt ty die Schwellwertstufe 16 derart angesteuert wird, daß die Register 14 übernehmen. Das bewirkt, daß das Vergleichssignal VS.y zu einem Zeitpunkt nach "1" geschaltet wird, der nahezu gleich ist mit dem Zeitpunkt tm, an dem die negative Flanke (von "1" nach "0") des Referenzsignales auftritt.

Bei einem dritten Beispiel möge die Umschaltung der Schwellwertstufe 16 zu einem Zeitpunkt tz erfolgen. Das dazugehörige Vergleichssignal VS.z wird erst zu einem späteren Zeitpunkt nach eins umgeschaltet, der nahezu identisch ist mit dem Zeitpunkt tn, an dem die positive Flanke (von "0" nach "1") des Referenzsignales auftritt.

Die Register 19, 20 arbeiten derart, daß ein Signal, das an ihrem Eingang anliegt, zu einem Zeitpunkt übernommen wird, an dem eine Flanke einer vorgegebenen Richtung, positiv oder negativ, anliegt. Würden beide Register mit derselben Flanke des Referenzsignales angesteuert werden, so könnte es vorkommen, daß die zu dem Zeitpunkt ty, bzw. zu dem Zeitpunkt tz auftretende signifikante Änderung des Testsignales Ts zu der ersten oder zu einer späteren Periodendauer des Referenzsignales gezählt wird. Dadurch würde bei der Phasenmessung eine Unsicherheit von einer Periodendauer bewirkt.

Da in diesem Ausführungsbeispiel jedoch die Register 19, 20 mit verschiedenen Phasen des Referenzsignales Rs angesteuert werden, werden, wenn die Register durch eine positive Flanke ansteuerbar sind, die Vergleichssignale der ersten Gruppe zu dem Zeitpunkt tn und die Vergleichssignale der zweiten Gruppe zu dem Zeitpunkt tm bzw. tm' durch die Register 19 bzw. 20 verarbeitet. Damit ist eine eindeutige Phasenzuordnung des Testsignales zu dem Referenzsignal gewährleistet.

Die Entscheidung, welche Vergleichssignale der ersten und welche der zweiten Gruppe zugeordnet werden, ist im wesentlichen abhängig von den Laufzeitverzögerungen des verwendeten Systems. Wenn in diesem Ausführungsbeispiel davon ausgegangen wird, daß durch die Stufen 16, 17, 18 jeweils um eine Zeiteinheit verzögert wird, so treten die Vergleichssignale Vs zu einem Zeitpunkt tx+3, ty+3, bzw. tz+3 auf.

Damit Unsicherheiten vermieden werden, muß also gewährleistet werden, daß diejenigen Vergleichssignale Vs, die mit der Flanke zum Zeitpunkt tm übernommen werden, nicht zu diesem Zeitpunkt auftreten. Das heißt, sie dürfen entweder immer nur vor tm oder immer nur nach tm auftreten.

Analoges gilt für diejenigen Vergleichssignale Vs, die mit der Flanke zum Zeitpunkt tn übernommen werden.

Versionen des genannten Ausführungsbeispieles können mindestens eine der folgenden Variationen aufweisen:
- anstatt jedes der Vergleichssignale über eine eigene Vergleichsleitung zu führen, können mehrere oder auch alle Vergleichssignale Vs, beispielsweise mit Hilfe von Zeit- und/oder Frequenzmultiplexverfahren, über eine gemeinsame Leitung geführt werden. Die Aufteilung in die beiden Gruppen ist beispielsweise mittels eines Schaltmittels möglich, das durch die Vergleichssignale oder zeitlich gesteuert werden kann;
- die Ausgänge der Register 19, 20 können auch ohne Register 22 über das ODER-Gatter 23 zum zurücksetzen (reset) verwendet werden;
- es können verschiedenartige Register 19, 20 derart verwendet werden, daß beispielsweise das Register 19 bei der ansteigenden Flanke des Signales Rs die Vergleichssignale Vs übernimmt und das Register 20 bei einer abfallenden Flanke des Signales Rs. In diesem Fall kann auf den Inverter 21 verzichtet werden;
- das Signal Rs muß nicht von dem Oszillator 10 erzeugt werden. Stattdessen kann Rs von einer beliebigen anderen Stufe erzeugt werden, oder von dem Systemtakt, der auch den Oszillator 10 synchronisieren kann, in beliebiger Weise abgeleitet werden.

Ergänzend sei erwähnt, daß die Erfindung bei der Verarbeitung von Fernsehsignalen verwendet werden kann.

## Patentansprüche

1. Verfahren zur Messung der Phasenlage eines Testsignals (Ts) bezüglich eines Referenzsignals (Rs), wobei auf Grund von signifikanten Änderungen des Testsignals (Ts) durch Vergleich mit dem Referenzsignal (Rs) ein Zustand bei einem von mehreren Vergleichssignalen (Vs.1 bis Vs.n) verändert wird, **dadurch gekennzeichnet**, daß eine erste Gruppe der Vergleichssignale (Vs.1 bis Vs.n) weiterverarbeitet wird auf Grund einer ersten Phasenlage des Referenzsignals (Rs) und eine zweite Gruppe der Vergleichssignale (Vs.1 bis Vs.n) weiterverarbeitet wird auf Grund einer zweiten Phasenlage des Referenzsignals (Rs), wobei die Gruppeneinteilung der Vergleichssignale (Vs.1 bis Vs.n) so vorgenommen wird, daß zu den Zeitpunkten (tn, t'm), an denen die erste oder zweite Phasenlage des Referenzsignals (Rs) auftritt, eine Änderung der jeweils zu diesen Zeitpunkten (tn, t'm) weiterverarbeiteten Vergleichssignale (Vs.1 bis Vs.n) nicht mehr möglich ist.

2. Vorrichtung zur Erkennung der Phasenlage eines Testsignals (Ts) bezüglich eines Referenzsignals (Rs) wobei erste Mittel (16, 17, 18) vorgesehen sind, die bei signifikanten Änderungen des Testsignals (Ts) einen Zustand bei einem von mehreren Vergleichssignalen (Vs.1 bis Vs.n) ändern, **dadurch gekennzeichnet, daß**
- zweite Mittel (19) vorgesehen sind, die auf Grund einer ersten Phasenlage des Referenzsignals (Rs) eine erste Gruppe von Vergleichssignalen weiterverarbeiten und daß
- dritte Mittel (21, 20) vorgesehen sind, die auf Grund einer zweiten Phasenlage des Referenzsignals (Rs) eine zweite Gruppe von Vergleichssignalen (Vs.1 bis Vs.n) verarbeiten, wobei die Gruppeneinteilung der Vergleichssignale (Vs.1 bis Vs.n) so vorgenommen ist, daß zu den Zeitpunkten (tn, t'm), an denen die erste oder zweite Phasenlage des Referenzsignals (Rs) auftritt, eine Änderung der jeweils zu diesen Zeitpunkten weiterverarbeiteten Vergleichssignale (Vs. bis Vs.n) nicht mehr möglich ist.

3. Vorrichtung nach Anspruch 2, dadurch gekennzeichnet, daß jedes der Vergleichssignale (Vs) über eine eigene Vergleichsleitung geführt wird und daß eine erste Gruppe der Vergleichsleitungen mit den zweiten Mitteln (19) und eine zweite Gruppe von Vergleichsleitungen mit den dritten Mitteln (21, 20) verbunden ist.

4. Vorrichtung nach einem der Ansprüche 2 oder 3, dadurch gekennzeichnet, daß die zweiten Mittel ein erstes Register (19) und die dritten Mittel ein zweites Register (20) enthalten, das über einen Inverter (21) angesteuert wird.

## Claims

1. Method of measuring the phase angle of a test signal (Ts) with respect to a reference signal (Rs), wherein a state of one of a plurality of comparison signals (Vs.1 to Vs.n) is altered on the basis of significant changes in the test signal (Ts) by comparison with the reference signal (Rs),
characterised in that, a first group of the comparison signals (Vs.1 to Vs.n) is processed on the basis of a first phase angle of the reference signal (Rs) and a second group of the comparison signals (Vs.1 to Vs.n) is processed on the basis of a second phase angle of the reference signal (Rs), whereby the grouping of the comparison signals (Vs.1 to Vs.n) is effected such that, at the time points (tn, t'm) at which the first or second phase angle of the reference signal (Rs) occurs, an alteration of the particular comparison signals (Vs.1 to Vs.n) that are being processed at these time points (tn, t'm) can no longer be made.

2. Device for identifying the phase angle of a test signal (Ts) with respect to a reference signal (Rs) wherein first means (16, 17, 18) are provided for altering a state of one of a plurality of comparison signals (Vs.1 to Vs.n) when there are significant changes in the test signal (Ts), characterised in that,
- second means (19) are provided for processing a first group of comparison signals on the basis of a first phase angle of the reference signal (Rs) and that
- third means (21, 20) are provided for processing a second group of comparison signals (Vs.1 to Vs.n) on the basis of a second phase angle of the reference signal (Rs), whereby the grouping of the comparison signals (Vs.1 to Vs.n) is effected such that, at the time points (tn, t'm) at which the first or second phase angle of the reference signal (Rs) occurs, an alteration of the particular comparison signals (Vs.1 to Vs.n) that are being processed at these time points can no longer be made.

3. Device in accordance with Claim 2, characterised in that, each of the comparison signals (Vs) is conducted over its own comparison line and that a first group of comparison lines is connected to the second means (19) and a second group of comparison lines is connected to the third means (21, 20).

4. Device in accordance with either of Claims 2 or 3, characterised in that, the second means includes a first register (19) and the third means includes a second register (20) which is controlled via an invertor (21).

## Revendications

1. Un procédé de mesure de la position de phase d'un signal de test (Ts) par rapport à un signal de référence (Rs), par lequel suite à des modifications significatives du signal de test (Ts) par comparaison avec le signal de référence (Rs) un état d'un de plusieurs signaux de comparaison (Vs.1 à Vs.n) sera modifié, **caractérisé en ce qu**'un premier groupe de signaux de comparaison (Vs.1 à Vs.n) sera traité en fonction d'une première position de phase du signal de référence (Rs) et un second groupe de signaux de comparaison (Vs.1 à Vs.n) sera traité en fonction d'une seconde position de phase du signal de référence (Rs), pour lequel la répartition par groupes des signaux de comparaison (Vs.1 à Vs.n) s'effectuera de telle sorte qu'aux instants (tn, t'm) auxquels la première ou seconde position de phase du signal de référence (Rs) apparaît, une modification des signaux de comparaison respectifs (Vs.1 à Vs.n) traités à ces instants (tn, t'm) ne sera plus possible.

2. Dispositif de détermination de la position de phase d'un signal de test (Ts) par rapport à un signal de référence (Rs), pour lequel des premiers moyens (16, 17, 18) sont prévus qui peuvent modifier un état d'un de plusieurs signaux de comparaison (Vs.1 à Vs.n) en cas de modification significative du signal de test (Ts), **caractérisé en ce que**
- des deuxièmes moyens (19) sont prévus pour traiter un premier groupe de signaux de comparaison en fonction d'une première position de phase du signal de référence (Rs),
- des troisièmes moyens (21, 20) sont prévus pour traiter un second groupe de signaux de comparaison(Vs.1 à Vs.n), pour lequel la répartition par groupes des signaux de comparaison (Vs.1 à Vs.n) s'effectuera de telle sorte qu'aux instants (tn, t'm) auxquels la première ou seconde position de phase du signal de référence (Rs) apparaît, une modification des signaux de comparaison respectifs (Vs.1 à Vs.n) traités à ces instants (tn, t'm) ne sera plus possible.

3. Dispositif selon la revendication 2, **caractérisé en ce que** chaque signal de comparaison (Vs) est acheminé via une liaison de comparaison propre et qu'un premier groupe de liaisons de comparaison est relié aux deuxièmes moyens (19) et un deuxième groupe de liaisons de comparaison est relié aux troisièmes moyens (21, 20).

4. Dispositif selon la revendication 2 ou 3, **caractérisé en que** les seconds moyens comprennent un premier registre (19) et les troisièmes moyens un second registre (20) commandé via un inverseur (21).
